# EUROPÄISCHE PATENTSCHRIFT

(11) **EP 2 797 064 B1**
(45) Veröffentlichungstag und Bekanntmachung des Hinweises auf die Patenterteilung: **19.06.2019**
(21) Anmeldenummer: 14001434.1
(22) Anmeldetag: 22.04.2014
(51) Int. Cl.: G08G 1/054, F16M 11/08, G01D 11/24, G08G 1/017, H05K 5/00, H02B 1/30

(54) **Vorrichtung für eine Anlage zur Verkehrsüberwachung von Fahrzeugen im Straßenverkehr**
Device for a system for monitoring vehicles in traffic
Dispositif pour une installation de surveillance du trafic de véhicules dans le trafic routier

(30) Priorität: 23.04.2013 DE 102013006942
(43) Veröffentlichungstag der Anmeldung: 29.10.2014
(73) Patentinhaber: JENOPTIK Robot GmbH, 40789 Monheim am Rhein (DE)
(72) Erfinder: Pätzoldt, Volker, 25746 Heide (DE); Bünger, Thomas, 25746 Lohe-Rickelshof (DE); Maserski, Stephan, 44269 Dortmund (DE); Friessner, Jörg, 51371 Leverkusen (DE)
(74) Vertreter: Waldauf, Alexander

(56) Entgegenhaltungen:
- EP-A2- 1 148 457
- EP-A2- 1 182 759
- FR-A1- 2 962 245

## Beschreibung

Die vorliegende Erfindung bezieht sich auf eine Vorrichtung für eine Anlage zur Verkehrsüberwachung von Fahrzeugen im Straßenverkehr.

In der Verkehrsüberwachungstechnik werden Vorrichtungen, die eine Strahlung aussenden und/oder empfangen, gemeinsam mit Beleuchtungseinrichtungen (hier auch Gerätemodule genannt) in einer Vorrichtung untergebracht, welche stationär in einem Bereich neben zumindest einer Fahrbahn montiert wird. Neben den stationären Geräten zur Verkehrsüberwachung gibt es solche, die in Fahrzeuge eingebaut werden oder von Verkehrsüberwachungspersonal bedient werden können. Hierbei muss zur Überwachung auch immer ein Fahrzeug oder entsprechend Personal vorgehalten werden. An ungewöhnlicher Stelle geparkte Fahrzeuge fallen dabei den Verkehrsteilnehmern auf. Bei anderen Verkehrsüberwachungsgeräten werden Radargerät, Kamera, Blitzgerät und Bediengerät gesondert aufgestellt. Das erfordert vor dem Einsatz eine genaue Ausrichtung der einzelnen Teile zueinander und in Bezug zur zu überwachenden Fahrbahn, ganz zu schweigen von einem erhöhten Personalbedarf. Dabei können die Geräte in unerwünschter Weise der Witterung ausgesetzt sein. Verkehrsüberwachungsgeräte mit einer Kamera und einem Blitzgerät in einem quaderförmigen Behälter, der Fenster für die Kamera und das Blitzgerät aufweist, sind bekannt. Da derartige Verkehrsüberwachungsgeräte schwer und unhandlich sein können, sind zum Aufstellen der Verkehrsüberwachungsgeräte und zum Ausladen aus einem Fahrzeug und Einladen in das Fahrzeug mehrere Personen erforderlich.

In der Gebrauchsmusterschritt DE 20 2010 009 315 U1 wird eine Vorrichtung für eine stationäre Anlage zur Geschwindigkeitsüberwachung offenbart. Auch in der Offenlegungsschrift DE 10017575 A1 wird ein Verkehrsüberwachungsgerät offenbart.

Vor diesem Hintergrund wird mit der vorliegenden Erfindung eine Vorrichtung für eine Anlage zur Verkehrsüberwachung von Fahrzeugen im Straßenverkehr gemäß dem Hauptanspruch vorgestellt. Vorteilhafte Ausgestaltungen ergeben sich aus den Unteransprüchen und der nachfolgenden Beschreibung.

Mit einem quasistationären und gleichzeitig transportablen Verkehrsüberwachungsgerät können Vorteile einer stationären Lösung und einer mobilen Lösung miteinander kombiniert werden. Wenn weiterhin das Verkehrsüberwachungsgerät modular aufgebaut ist, kann es einfach und kostengünstig an sich ändernde Aufgaben angepasst werden. Dabei erlaubt eine modulare Lösung auch den Einsatz unterschiedlicher Materialien, um die Gesamtlösung einer Vorrichtung für eine Anlage zur Verkehrsüberwachung von Fahrzeugen im Straßenverkehr leicht und trotzdem robust zu gestalten.

Es wird vorliegend eine Vorrichtung für eine Anlage zur Verkehrsüberwachung von Fahrzeugen im Straßenverkehr vorgestellt, wobei die Vorrichtung einen ersten Halterahmen und einen zweiten Halterahmen aufweist, die mit innenliegenden Fixierelementen gegeneinander sicherbar oder gesichert sind, wobei zumindest der erste Halterahmen eine quaderförmige, Form aufweist, wobei in dem ersten Halterahmen zumindest eine Einrichtung zum Erfassen einer Verkehrssituation anordenbar oder angeordnet ist, dadurch gekennzeichnet, dass zumindest der erste Halterahmen von vier Seiten zugänglich ist.

Unter einer Anlage zur Verkehrsüberwachung von Fahrzeugen im Straßenverkehr kann eine Anlage verstanden werden, die geeignet ist, eine Geschwindigkeitsüberwachung, eine Rotlichtüberwachung, eine kombinierte Rotlicht- und Geschwindigkeitsüberwachung oder eine sonstige Überwachung von Verkehrsverstößen durchzuführen. Dabei kann die Vorrichtung für die Anlage zur Verkehrsüberwachung als eine stationäre, quasi stationäre oder alternativ als eine mobile Vorrichtung für eine Anlage zur Verkehrsüberwachung ausgeführt sein. Die Anlage zur Verkehrsüberwachung umfasst zumindest eine Einrichtung zum Erfassen einer Verkehrssituation, die in dem ersten Halterahmen der Vorrichtung angeordnet ist. Unter einer Einrichtung zum Erfassen einer Verkehrssituation kann beispielsweise ein Radarsensor- oder Lidargerät, eine Kamera, ein Mittel zur Messung der Geschwindigkeit, optische, opto-elektrische oder elektromagnetische Mess- oder Aufnahmegeräte oder dergleichen oder einer Kombination der vorstehend gekannten Elemente verstanden werden. In einer Ausführungsform kann die zumindest eine Einrichtung zum Erfassen einer Verkehrssituation in einem Einschub in den Halterahmen hineingeschoben werden. Zumindest der erste Halterahmen kann von vier Seiten zugänglich sein. So kann der erste Halterahmen beispielsweise im montierten Zustand in einer Ebene aus allen Richtungen zugänglich sein oder alternativ zumindest aus vier senkrecht aufeinander stehenden Richtungen in einer Ebene zugänglich sein. So kann in einer Ausführungsform der erste Halterahmen vier zueinander ausgerichtete Pfosten aufweisen, die hierzu senkrecht stehende Einlegeböden oder Schienen zum Einschieben eines Einschubes aufweisen. Eine Vorrichtung für eine Anlage zur Verkehrsüberwachung kann beispielsweise neben einer Fahrbahn einer Straße, zwischen zwei Fahrbahnen einer Straße oder alternativ über einer Fahrbahn einer Straße angeordnet werden. Eine Vorrichtung für eine Anlage zur Verkehrsüberwachung kann in einer vorbestimmten geometrischen Beziehung zu zumindest einer Fahrbahn einer Straße stehen.

Ferner kann der zweite Halterahmen an der dem ersten Halterahmen gegenüberliegenden Seite mit einer an einem Messplatz montierten Bodenplatte fixierbar sein. Dabei kann die Bodenplatte in Bezug auf den Messplatz in einem Toleranzbereich ausrichtbar sein. Der Toleranzbereich kann ±5° betragen. In einer günstigen Ausführungsform kann der Toleranzbereich ±25° betragen. Der Winkel der Bodenplatte zu dem Messplatz kann zu einer Ebene parallel und gleichzeitig oder alternativ senkrecht zur Fahrbahn ausrichtbar sein. Dabei kann unter einem Messplatz ein Fundament verstanden werden, welches in einem Bereich neben der Fahrbahn fest angeordnet ist. Unter der Bodenplatte kann eine Montageplatte verstanden werden, die mittels Fixierelementen, wie beispielsweise Schrauben, Stiften oder Bolzen mit dem Messplatz und geleichzeitig oder alternativ mit dem zweiten Halterahmen verbindbar ist oder verbunden ist. Dabei kann die Bodenplatte vorgesehen sein, fest mit dem Messplatz verbunden zu sein. Dabei kann die Bodenplatte flexibel mit dem zweiten Halterahmen bei Bedarf verbunden werden, wenn die Vorrichtung für eine Anlage zur Verkehrsüberwachung von Fahrzeugen im Straßenverkehr quasistationär auf der Bodenplatte verankert werden soll. Ebenso einfach kann die Vorrichtung für eine Anlage zur Verkehrsüberwachung von Fahrzeugen im Straßenverkehr von der Bodenplatte gelöst und an einen anderen Bestimmungsort gebracht werden. Vorteilhaft ist an einem Messplatz eine fest verschraubbare und dort verbleibende quadratische Bodenplatte montiert. Dabei kann auf der Bodenplatte eine Abdeckung zum Schutz der Bodenplatte angeordnet werden, wenn keine Vorrichtung bzw. kein zweiter Halterahmen oder zweites Gehäuse dort montiert ist.

Günstig ist es auch, wenn der der zweite Halterahmen in einem Toleranzbereich um ein ganzzahliges Vielfaches von 90° verdreht auf der Bodenplatte montierbar ist. So kann der Halterahmen in einer Ausführungsform in einem Toleranzbereich um 90 Grad oder 180 Grad oder 270 Grad verdreht montierbar sein. Dabei kann der Toleranzbereich einige wenige Grad bis zu ±25 Grad betragen. Um den Halterahmen um ein Vielfaches (welches auch den Faktor 1 einschließt) von 90 Grad verdreht auf der Bodenplatte montieren zu können, kann die Bodenplatte quadratisch und gleichzeitig achsensymmetrisch aufgebaut sein. Auf diese Weise kann die Vorrichtung einfach von einer Überwachung des ankommenden Verkehrs auf eine Überwachung des abfließenden Verkehrs umgerüstet werden, ohne eine neue Bodenplatte oder eine neue oder andere Montageplatte zu benötigen. Auf diese Weise kann günstig ein flexibles Überwachungssystem geschaffen werden.

In einer Ausführungsform weist die Vorrichtung zumindest ein Gehäuse auf. Das Gehäuse kann mit zumindest einer Tür ausgestattet sein, insbesondere wobei der erste und/oder zweite Halterahmen in den Gehäuse anordenbar oder angeordnet sind. Das Gehäuse kann den ersten Halterahmen umschließen. Alternativ kann das Gehäuse den zweiten Halterahmen umschließen. In einer Ausführungsform umschließt das Gehäuse den ersten Halterahmen und gleichzeitig den zweiten Halterahmen. Günstig ist es auch, wenn der erste Halterahmen ein erstes Gehäuse aufweist und der zweite Halterahmen ein vom ersten Gehäuse unterschiedliches zweites Gehäuse aufweist. In einer günstigen Ausführungsform weisen der erste Halterahmen und der zweite Halterahmen je ein eigenes Gehäuse auf. Mit einem Gehäuse kann die Anlage zur Verkehrsüberwachung beispielsweise vor Witterungseinflüssen oder Vandalismus einfach und effizient geschützt werden.

Günstig ist es auch, wenn das Gehäuse zumindest eine Flügeltüre aufweist. In einer Ausführungsform kann das Gehäuse zumindest zwei Flügeltüren aufweisen. Wenn das Gehäuse zwei Flügeltüren aufweist, können die in einem gemeinsamen Scharnier verbunden sein. Zwei Flügeltüren können zumindest einen Halterahmen komplett umschließen. Ein Scharnier der zumindest einen Flügeltür kann an einer Kante oder einer Anschlagsecke des Gehäuses beziehungsweise des Halterahmens angeordnet sein. Insbesondere können zwei Flügeltüren den ersten Halterahmen komplett umschließen. Somit weist die Vorrichtung für eine Anlage zur Verkehrsüberwachung einen ersten geschlossenen Zustand auf, in dem die zwei Flügeltüren den Halterahmen komplett umschließen und einen zweiten geöffneten Zustand, in dem der erste Halterahmen von vier Seiten zugänglich ist.

Entsprechend einer Ausführungsform der vorliegenden Erfindung weist das Gehäuse auf drei Seiten des Gehäuses zumindest je ein Fenster auf. Ein Fenster kann ausgebildet sein, dass Strahlung aussendende und/oder empfangende Gerätemodule wie beispielsweise optische, opto-elektrische oder elektromagnetische Mess- oder Aufnahmegeräte durch das Fenster elektromagnetische Strahlen senden und/oder empfangen. Insbesondere kann die Einrichtung zum Erfassen zumindest ein Teilelement aufweisen, welches zum Aussenden oder Empfangen von elektromagnetischer Strahlung durch das zumindest ein Fenster ausgerichtet ist. So können Geräte, die im Inneren des Gehäuses angeordnet sind, durch das Fenster eine Verkehrsüberwachung außerhalb des Gehäuses wahrnehmen. Wenn die Vorrichtung für eine Anlage zur Verkehrsüberwachung an zumindest zwei Seiten, insbesondere an drei Seiten, des ersten Gehäuses Fenster aufweist, so kann die Vorrichtung oder das Gehäuse der Vorrichtung wahlweise entweder für ankommenden Verkehr oder für abfliesenden Verkehr eingesetzt werden.

Ferner kann das Gehäuse eine spezifische Schutzklasse aufweisen. Ferner kann das Gehäuse eine spezifische Schutzart aufweisen. Eine spezifische Schutzklasse oder Schutzart kann insbesondere durch eine Auswahl oder Festlegung eines Materials des Gehäuses erzielt werden. Die Schutzart des Gehäuses kann die Anlage zur Verkehrsüberwachung für verschiedene Umgebungsbedingungen schützen. So kann das Gehäuse in einer Ausführungsform schusssicher ausgebildet sein. So kann das Gehäuse die Fähigkeit aufweisen, die Anlage zur Verkehrsüberwachung vor Geschossen bestimmter Art oder Kaliber zu schützen.

Günstig ist es auch, wenn der zweite Halterahmen, oder eine Vorrichtung die in dem zweiten Halterahmen angeordnet ist, als eine autonome Energieversorgungseinheit ausgebildet ist. Alternativ kann in dem zweiten Halterahmen eine autonome Energieversorgungseinheit angeordnet sein. So kann der zweite Halterahmen so gestaltet sein, dass der darin montierte Akkumulator oder Batterie gewechselt wird, während der zweite Halterahmen an der Vorrichtung verbleibt oder der gesamte Halterahmen samt Akkumulator bzw. Batterie als Akku-Pack verwendet und gewechselt wird. Auch kann der zweite Halterahmen oder eine Vorrichtung in dem zweiten Halterahmen einer Aufbereitung einer extern zugeführten Energie dienen. Wenn der zweite Halterahmen eine autonome Energieversorgungseinheit bereitstellt, kann zur Inbetriebnahme der Vorrichtung für eine Anlage zur Verkehrsüberwachung von Fahrzeugen im Straßenverkehr nur eine Zuleitung an den den ersten Halterahmen mit einer Leitung der autonomen Energieversorgungseinheit verbunden werden.

Wenn die Vorrichtung für eine Anlage zur Verkehrsüberwachung von Fahrzeugen innenliegende Fixierelemente zur Verbindung der Bodenplatte mit dem zweiten Halterahmen und gleichzeitig oder alternativ des zweiten Halterahmens mit dem ersten Halterahmen aufweist, so ist die Vorrichtung vorteilhaft diebstahlsicher. Da die Bodenplatte in Bezug zu dem Messplatz ausgerichtet werden kann, ist nur eine einmalige Ausrichtung durch qualifiziertes Personal notwendig, und wenn die quasi stationäre Vorrichtung an diesem Ort aufgestellt wird, die Kombination einer fest montierten Bodenplatte mit zwei modularen Gehäusen führt zu einer quasi stationären transportablen Vorrichtung für eine Anlage zur Verkehrsüberwachung. Somit können die Vorteile einer genau justierten, stationären Vorrichtung mit den Vorteilen einer transportablen Vorrichtung kombiniert werden. Das modulare Konzept erlaubt es sich jederzeit zwischen Batteriewechsel, Akkupackwechsel und Netzversorgung flexibel zu entscheiden, wobei auch ein Mischbetrieb möglich ist. Ein modulares Konzept, wie es vorstehend beschrieben ist, erlaubt es zudem das Innenleben, das heißt beispielsweise die Halterahmen, aus leichtem und preiswertem Aluminium zu bauen und die Außenhülle an die Schutzklassen oder das Designkonzept beispielsweise durch den Einsatz von rostfreiem Stahl, anzupassen. Durch eine Mehrteiligkeit kann das Gehäuse als Gesamtsystem von zwei Personen ohne Kran oder von einer Person mit Kran aufgebaut werden.

Die Erfindung wird nachstehend anhand der beigefügten Zeichnungen beispielhaft näher erläutert. Es zeigen:
- Fig. 1: eine Darstellung einer Vorrichtung für eine Anlage zur Verkehrsüberwachung von Fahrzeugen im Straßenverkehr gemäß einem Ausführungsbeispiel der vorliegenden Erfindung auf einem Messplatz neben einer Straße;
- Fig. 2: eine Darstellung einer Vorrichtung für eine Anlage zur Verkehrsüberwachung gemäß einem Ausführungsbeispiel der vorliegenden Erfindung in einem geschlossenen Zustand;
- Fig. 3: eine Darstellung einer Vorrichtung für eine Anlage zur Verkehrsüberwachung gemäß einem Ausführungsbeispiel der vorliegenden Erfindung in einem geöffneten Zustand;
- Fig. 4: eine Explosionsdarstellung einer Vorrichtung für eine Anlage zur Verkehrsüberwachung gemäß einem Ausführungsbeispiel der vorliegenden Erfindung ;
- Fig. 5: eine Darstellung einer Vorrichtung für eine Anlage zur Verkehrsüberwachung mit Flügeltüren gemäß einem Ausführungsbeispiel der vorliegenden Erfindung; und
- Fig. 6: eine Darstellung einer Vorrichtung für eine Anlage zur Verkehrsüberwachung mit auffaltenden Türen gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

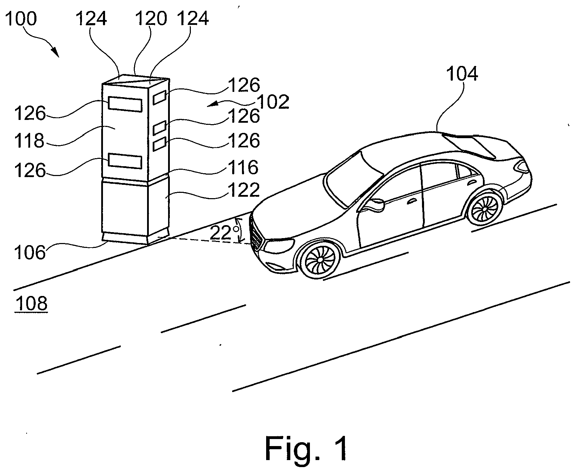

Fig. 1 zeigt eine Vorrichtung 100 für eine Anlage 102 zur Verkehrsüberwachung von Fahrzeugen 104 im Straßenverkehr auf einem Messplatz 106 neben einer Straße 108 gemäß einem Ausführungsbeispiel der vorliegenden Erfindung. Neben der Straße 108 ist auf dem Messplatz 106 eine, in Fig. 1 nicht dargestellte, Bodenplatte angeordnet. Die Bodenplatte kann mit einem Fundament beispielsweise aus Beton verbunden sein. Auf der Bodenplatte ist die Vorrichtung 100 für eine Anlage 102 zur Verkehrsüberwachung von Fahrzeugen 104 im Straßenverkehr angeordnet. In Fig. 1 weist die Vorrichtung 100 einen nicht dargestellten ersten Halterahmen und einen zweiten nicht dargestellten Halterahmen auf, die mit ebenfalls nicht dargestellten innenliegenden Fixierelementen verbunden sind. Dies gilt auch für die Verbindung des zweiten Halterahmens mit der Bodenplatte. In dem vorliegenden Ausführungsbeispiel weisen der erste Halterahmen und der zweite Halterahmen einen quadratischen Grundriss auf. Der zweite Halterahmen ist über die nicht dargestellte Bodenplatte mit dem Messplatz 106 verbunden, das heißt, der zweite Halterahmen steht auf dem Fundament. Auf der dem Fundament abgewandten Seite des zweiten Halterahmens ist der erste Halterahmen 110 angeordnet. Von dem quadratischen Grundriss der Halterahmen ausgehend, erstrecken sich die Halterahmen zylinderförmig und weisen somit jeweils eine quaderförmige Form auf. In dem ersten Halterahmen ist eine nicht dargestellte Einrichtung zum Erfassen einer Verkehrssituation angeordnet.

In dem in Fig. 1 dargestellten Ausführungsbeispiel weist die Vorrichtung 100 für eine Anlage 102 zur Verkehrsüberwachung von Fahrzeugen 104 ein Gehäuse 116 auf. Das Gehäuse 116 weist zumindest eine nicht dargestellte Tür auf. In diesem speziellen Ausführungsbeispiel ist das Gehäuse 116 zweigeteilt. So weist der erste Halterahmen ein erstes Gehäuse 120 auf und der zweite Halterahmen weist ein zweites Gehäuse 122 auf.

Bei der dem ersten Gehäuse 120 zugeordneten Tür 118 handelt es sich bei dem in Fig. 1 gezeigten Ausführungsbeispiel um eine Flügeltüre 124. Dabei kann das erste Gehäuse 120, wie in einem der folgenden Ausführungsbeispiele dargestellt, zwei Flügeltüren 124 aufweisen, die beispielsweise über ein gemeinsames Scharnier an einer Außenkante des ersten Halterahmens zu öffnen sind. Bei dem ersten Gehäuse 120 sind fünf Fenster 126 sichtbar, wobei in dem geschlossenen Gehäuseteil der Straße zugewandt drei Fenster 126 angeordnet sind und zwei weitere Fenster 126 hierzu 90° versetzt in der Flügeltür 124 angeordnet ist. Dabei kann die Vorrichtung 100 zumindest ein weiteres Fenster 126 auf einer von dem Betrachter abgewandten Seite, insbesondere auf der diametral gegenüberliegenden Seite mit den zwei Fenstern, aufweisen.

Je nach Ausführungsbeispiel kann das Gehäuse 116 bzw. das erste Gehäuse 120 und gleichzeitig oder alternativ das zweite Gehäuse 122 eine spezifische Schutzklasse aufweisen. Dabei kann das erste Gehäuse 120 eine von dem zweiten Gehäuse 122 verschiedene Schutzklasse aufweisen. Eine spezifische Schutzklasse kann insbesondere durch die Auswahl eines besonders günstigen Materials des Gehäuses erzielt werden. So kann in einem Ausführungsbeispiel das Gehäuse 116 bzw. das erste Gehäuse 120 und gleichzeitig oder alternativ das zweite Gehäuse 122 schusssicher ausgebildet sein.

Der erste Halterahmen ist derart ausgebildet, das er von vier Seiten zugänglich ist, wobei unter den vier Seiten die zu der dem zweiten Halterahmen zugewandten Seite benachbarten Seiten verstanden werden können.

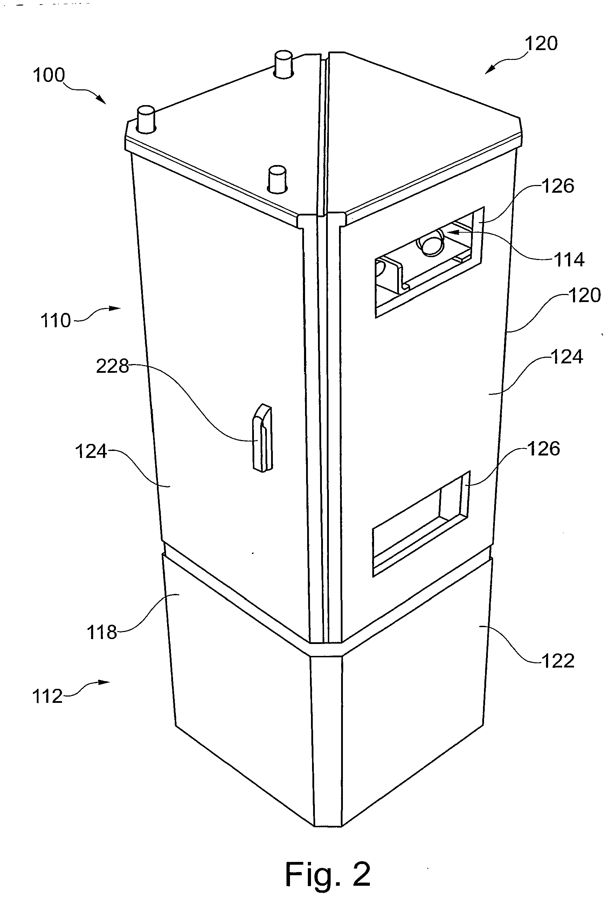

Fig. 2 zeigt eine Vorrichtung 100 für eine Anlage 102 zur Verkehrsüberwachung in einem geschlossenen Zustand gemäß einem Ausführungsbeispiel der vorliegenden Erfindung. Bei der Vorrichtung 100 kann es sich um die bereits in Fig. 1 beschriebene Vorrichtung 100 für eine Anlage 102 zur Verkehrsüberwachung handeln. Die Vorrichtung 100 ist in einem geschlossenen Zustand dargestellt. Die zwei Halterahmen sind durch die ihnen zugeordneten Gehäuse, das heißt das erste Gehäuse 120 sowie das zweite Gehäuse 122 verdeckt. Das erste Gehäuse 120 weist zwei Flügeltüren 124 auf. Eine der beiden Flügeltüren 124 weist wie in Fig. 1 dargestellt auf zwei Seiten Fenster auf, davon auf einer Seite zwei Fenster 126. Im Inneren der Vorrichtung 100 ist auf dem nicht dargestellten ersten Halterahmen eine fotografische Einrichtung zum Erfassen einer Verkehrssituation der Art angeordnet, dass die Einrichtung zum Erfassen einer Verkehrssituation durch das eine Fenster 126 nach außen gerichtet den Verkehr überwachen kann. An der Flügeltür 124, die kein Fenster 126 aufweist, ist ein Türgriff 228 angeordnet. Der Türgriff 228 kann mit einer Verriegelung versehen sein, die derart ausgebildet ist, dass bei einem Betätigen des Türgriffs 228 und somit einem Betätigen der zugeordneten Verriegelung die beiden Flügeltüren 124 des ersten Gehäuses 120 freigegeben werden und sich somit nach außen schwenken lassen. Dabei können in einem Ausführungsbeispiel die beiden Flügeltüren 124 ein gemeinsames Scharnier aufweisen.

In einem Ausführungsbeispiel weist die Vorrichtung 100 ein zweiteiliges Gehäuse auf. Die Vorrichtung 100 bzw. das zweiteilige Gehäuse der Vorrichtung 100 kann an dem Messplatz 106 mittels einer Bodenplatte angebracht werden. Dabei kann es sich bei einem Ausführungsbeispiel bei der Einrichtung 114 zum fotografischen Erfassen einer Verkehrssituation um eine Einzelbildkamera als auch um eine Videokamera handeln, die hinter dem oberen Fenster 126 positioniert ist. Hinter dem unteren Fenster ist eine Beleuchtungseinrichtung 117, insbesondere ein Blitzlicht positioniert. Dabei wird in einem Ausführungsbeispiel das Gehäuseunterteil, das heißt, das zweite Gehäuse 112 sowohl gegenüber der Bodenplatte als auch gegenüber dem Oberteil, das heißt, dem ersten Halterahmen beziehungsweise dem ersten Gehäuse 120 mit innenliegenden Fixierelementen, wie beispielsweise Schrauben, Bolzen mit Splint, Schnellverschluss oder Ähnliches, gesichert. Die der Seite mit dem Türgriff 228 diametral gegenüberliegende, abgewandte Seite weißt drei Fenster 126 auf, hinter der eine Einrichtung zum Erfassen der Verkehrssituation positioniert ist. Diese Einrichtung zum Erfassen der Verkehrssituation weißt eine wellenstrahlbasierte Sensorik, beispielsweise eine Sensorik, die eine Auswertung eines Strahls einer elektromagnetischen Welle ermöglicht, eine hochauflösende Kamera und einer Beleuchtungseinrichtung, insbesondere ein Blitzlicht, auf. Die Gehäuseseite mit der Sensorik ist die Seite, die bei der messtechnischen Überwachung von ankommendem Verkehr auf die Fahrzeugfront, insbesondere um 22° entgegen der Richtung der Fahrbahnen in den Verkehr gerichtet und bei der messtechnischen Überwachung von abfließendem Verkehr auf das Fahrzeugheck, insbesondere um 22° in Fahrtrichtung in den Verkehr gerichtet wird.

In einem Ausführungsbeispiel kann durch Variation des Materials der Flügeltüren 124 und der Hülle 122 des Akkupacks das Gehäuse 116 (120, 122) an verschiedene Schutzklassen oder Designkonzepte leicht angepasst werden, beispielsweise um das Gehäuse schusssicher auszuführen.

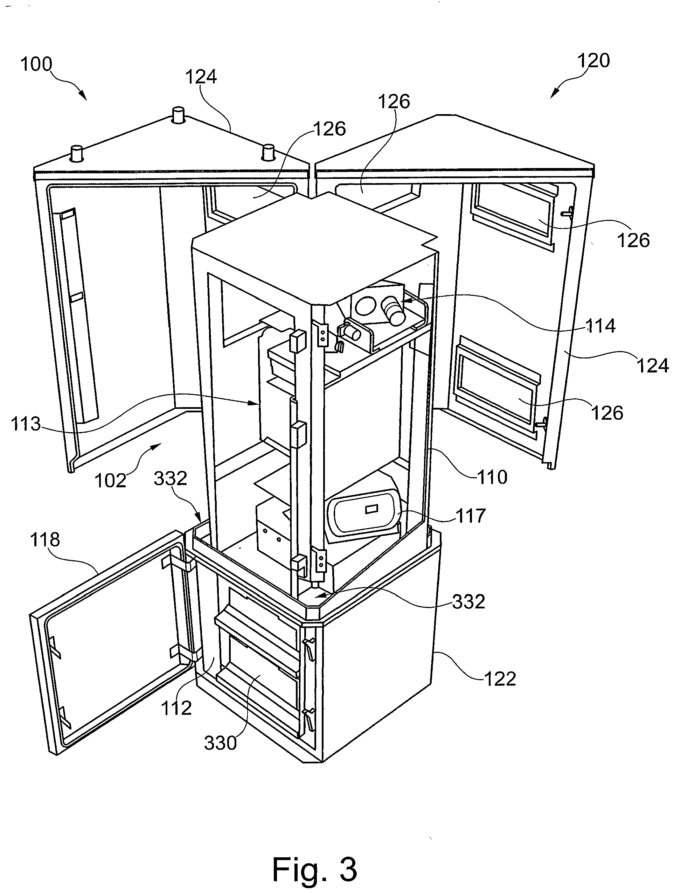

Fig. 3 zeigt eine Vorrichtung 100 für eine Anlage 102 zur Verkehrsüberwachung in einem geöffneten Zustand gemäß einem Ausführungsbeispiel der vorliegenden Erfindung. Bei der Vorrichtung 100 kann es sich um die in Fig. 1 oder alternativ um die in Fig. 2 beschriebene Vorrichtung 100 für eine Anlage 102 zur Verkehrsüberwachung handeln. In dem gezeigten Ausführungsbeispiel sind die zwei Flügeltüren 124 des ersten Gehäuses 120 geöffnet. Die beiden Flügeltüren 124 sind an einer Kante des ersten Halterahmens 110 angeschlagen. Die Flügeltüren 124 weisen Fenster 126 auf, wobei diese in einem geschlossenen Zustand auf drei unterschiedlichen Seiten des ersten Gehäuses 120 angeordnet sind. So weist die eine Flügeltür 124 auf einem Flügel zumindest ein Fenster 126 auf und die andere Flügeltür weist auf einem Flügel zwei Fenster 126 und auf dem anderen Flügel zumindest drei Fenster 126 auf. Das zweite Gehäuse 122 weist eine Tür 118 auf. In dem von dem zweiten Gehäuse 122 um geschlossenen zweiten Halterahmen 112 ist eine autonome Energieversorgung 330 angeordnet. In einem alternativen, nicht gezeigten Ausführungsbeispiel wird über den zweiten Halterahmen 112 bzw. das zweite Gehäuse 122 ein alternativer Netzanschluss zur Stromversorgung geführt.

Der zweite Halterahmen 112 ist mit dem ersten Halterahmen 110 über innenliegenden Fixierelementen 332 verbunden. Bei den innen liegenden Fixierelementen 332 kann es sich um Schrauben, Bolzen mit oder ohne Splint, einen Schnellverschluss oder Ähnliches handeln. In dem ersten Halterahmen 110 sind zumindest zwei Einrichtungen 113 und 114, insbesondere drei Einrichtungen angeordnet, wobei die dritte Einrichtung eine Videokamera ist, die nicht sichtbar oberhalb der Einrichtung 113 hinter der Einrichtung 114 angeordnet ist und durch das Fenster 126 der Flügeltür gerichtet ist, die nur ein Fenster aufweißt. Wobei die Einrichtung 113 zum Erfassen der Verkehrssituation eine wellenstrahlbasierte Sensorik, beispielsweise eine Sensorik, die eine Auswertung eines Strahls einer elektromagnetischen Welle ermöglicht, eine hochauflösende Kamera und einer Beleuchtungseinrichtung, insbesondere ein Blitzlicht, aufweißt und zum Erfassen einer Verkehrssituation derart angeordnet ist, dass sie auf den Verkehr gerichtet ist. Wenn die Anlage 102 zur Verkehrsüberwachung des ankommenden Verkehrs eingesetzt wird und mit der fotografischen Überwachungseinrichtung der Einrichtung 113 die Fahrzeugfront fotografiert wird, wird zusätzlich mit der fotografischen Erfassungseinrichtung 114, das Fahrzeugheck fotografiert. Wenn die Anlage 102 zur Verkehrsüberwachung den abfließenden Verkehr eingesetzt wird und mit der fotografischen Überwachungseinrichtung der Einrichtung 113 das Fahrzeugheck fotografiert wird, wird zusätzlich mit der Videokamera die ankommenden Fahrzeuge aufgezeichnet. Die Einrichtungen 113, 114 und die Videokamera zum Erfassen einer Verkehrssituation sind Bestandteil der Anlage 102 zur Verkehrsüberwachung.

In einem Ausführungsbeispiel ist das komplette Gehäuse unterteilt, dass heißt der zweite Halterahmen 112 sowie das zweite Gehäuse 122 so gestaltet, dass es als Akku-Pack genutzt werden kann, zum elektrischen Anschluss muss dann nur noch die Zuleitung des Oberteils, das heißt, zumindest der Einrichtung 113 zum erfassen einer Verkehrssituation, die in dem ersten Halterahmen 110 angeordnet ist, mit der Leitung des Unterteils, das heißt, mit der Leitung der autonomen Energieversorgung 330, verbunden werden. Die Videokamera sowie die weitere Einricht 114 können vorzugsweise über die Einrichtung 113 mit Energie versorgt werden.

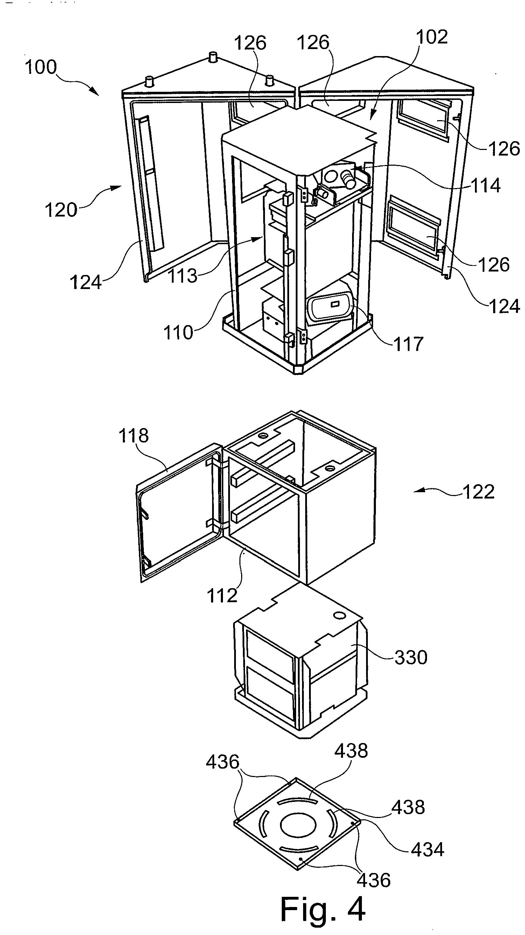

Fig. 4 zeigt eine Vorrichtung 100 für eine Anlage 102 zur Verkehrsüberwachung in einer Explosionsdarstellung gemäß einem Ausführungsbeispiel der vorliegenden Erfindung. Bei der in Fig. 4 gezeigten Vorrichtung 100 kann es sich um ein Ausführungsbeispiel der in den Figuren 1 bis 3 gezeigten Vorrichtung 100 für eine Anlage 102 zur Verkehrsüberwachung handeln. Durch die Explosionsdarstellung in Fig. 4 sind die einzelnen Elemente der Vorrichtung 100 gut zu erkennen. Ein erster Halterahmen 110 ist zu einem zweiten Halterahmen 112 ausgerichtet, wobei auf der dem ersten Halterahmen 110 abgewandten Seite des zweiten Halterahmen 112 eine Bodenplatte 434 angeordnet ist. In der Explosionsdarstellung zwischen der Bodenplatte 434 und dem zweiten Halterahmen 112 ist eine autonome Energieversorgung 330 dargestellt. Bei der autonomen Energieversorgung 330 kann es sich um einen Akku oder alternativ um eine Batterie handeln. Die autonome Energieversorgung 330 ist vorgesehen, innerhalb des zweiten Halterahmens 112 angeordnet zu werden. In dem ersten Halterahmen 110 sind zumindest zwei Einrichtungen 113 und 114, insbesondere drei Einrichtungen, wobei die dritte Einrichtung eine Videokamera ist, zum Erfassen einer Verkehrssituation angeordnet. Die zumindest zwei Einrichtungen 113 und 114 zum Erfassen einer Verkehrssituation sind Teil einer Anlage 102 zur Verkehrsüberwachung. Der zweite Halterahmen 112 weist ein zweites Gehäuse 122 auf, wobei das zweite Gehäuse auf einer Seite eine Tür 118 aufweist. Der erste Halterahmen 110 weist ein erstes Gehäuse 120 auf, wobei das erste Gehäuse 120 im Wesentlichen durch zwei Flügeltüren 124 gebildet wird. In den Flügeltüren 124 sind, wie bereits in der Beschreibung zu Fig. 3 beschrieben, eine Mehrzahl an Fenster 126 ausgebildet.

In dem in Fig. 4 gezeigten Ausführungsbeispiel weist die Bodenplatte 434 eine im Wesentlichen quadratische Grundform auf. An den Rändern der Bodenplatte 434 sind zumindest vier Löcher 436 ausgebildet. Die Löcher 436 sind ausgebildet, um hierüber die Bodenplatte 434 mit dem zweiten Halterahmen 112 zu verbinden. Der zweite Halterahmen 112 ist an der dem ersten Halterahmen 110 gegenüberliegenden Seite mit einer an einem Messplatz 106 montierten Bodenplatte 434 fixierbar. Dabei ist die Bodenplatte 434 in Bezug auf den Messplatz 106 in einem Toleranzbereich ausrichtbar. Hierzu weist die Bodenplatte 434 vier Aussparungen 438 in Form von Kreissegmenten auf. Im Bereich der Aussparungen 438 kann die Bodenplatte 434 mit entsprechenden Fixierelementen auf einem Fundament des Messplatzes 106 fixiert werden. So kann die Bodenplatte 434 zu dem Fundament beispielsweise in einem Bereich von ±25° ausgerichtet werden. In diesem Fall beträgt der beschriebene Toleranzbereich ±25°. In weiteren Ausführungsbeispielen kann der Toleranzbereich zum Ausrichten der Bodenplatte 434 in Bezug auf das Fundament beispielsweise ±5°, ±10°, ±15°, ±20° oder ±30° betragen.

Wenn, wie in dem in Fig. 4 gezeigten Ausführungsbeispiel, die Bodenplatte 434 im Wesentlichen eine quadratische Form aufweist, und der Grundriss des zweiten Halteelements 112 eine hierzu korrespondierende quadratische Form aufweist, so kann der zweite Halterahmen 112 in einem Toleranzbereich um ein Vielfaches von 90° verdreht auf der Bodenplatte montiert werden. So kann der zweite Halterahmen um 90°, 180° oder 270° verdreht auf der Bodenplatte fixiert werden. Dabei kann der Toleranzbereich weniger als ±5° betragen.

Wie bereits bei dem in Fig. 3 beschriebenen Ausführungsbeispiel kann in dem zweiten Halterahmen 112 eine autonome Energieversorgung 330 angeordnet werden. In einem alternativen Ausführungsbeispiel ist der zweite Halterahmen 112 als eine autonome Energieversorgung 330 ausgebildet.

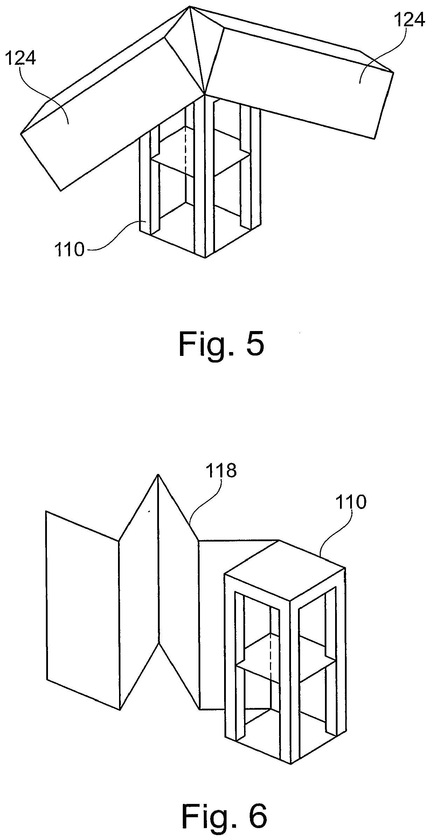

Fig. 5 zeigt eine Vorrichtung 100 für eine Anlage zur Verkehrsüberwachung mit Flügeltüren 124 gemäß einem Ausführungsbeispiel der vorliegenden Erfindung. Bei der Vorrichtung 100 für eine Anlage zur Verkehrsüberwachung kann es sich um ein Ausführungsbeispiel einer bereits in den Figuren Fig. 1 bis Fig. 4 beschriebenen Vorrichtung 100 für eine Anlage zur Verkehrsüberwachung handeln. Im Vergleich zu der in Fig. 4 beschriebenen Vorrichtung 100 sind die zwei Flügeltüren 124 nicht an einer Seitenkante des ersten Halterahmens 110 angeschlagen, sondern die zwei Flügeltüren 124 sind auf einer Diagonalen auf der dem zweiten Halterahmen 112 abgewandten Stirnfläche des ersten Halterahmens 110 angeordnet. Hierdurch schwenken im montierten Zustand die zwei Flügeltüren 124 jeweils nach oben.

Fig. 6 zeigt eine Vorrichtung 100 für eine Anlage zur Verkehrsüberwachung mit auffaltenden Türen 118 gemäß einem Ausführungsbeispiel der vorliegenden Erfindung. Bei der Vorrichtung 100 kann es sich um ein Ausführungsbeispiel einer in den Figuren Fig. 1 bis Fig. 5 gezeigten Vorrichtung 100 für eine Anlage zur Verkehrsüberwachung handeln. Bei dem in Fig. 6 gezeigten Ausführungsbeispiel sind vier Türflügel einer Tür 118 leporelloartig verbunden, sodass sich die Tür 118 auffalten lässt. Der Anschlag der in Fig. 6 gezeigten Tür 118 ist vergleichbar zu dem in Fig. 4 beschriebenen Ausführungsbeispiel. So ist der Anschlag für die Tür 118 an einer Seitenkante des ersten Halterahmens 110 angeordnet, wobei die Seitenkante senkrecht zu der dem zweiten Halterahmen 112 zugewandten Seitenfläche des ersten Halterahmens 110 steht.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### Bezugszeichenliste

- 100: Vorrichtung
- 102: Anlage zur Verkehrsüberwachung
- 104: Fahrzeug
- 106: Messplatz
- 108: Straße
- 110: erster Halterahmen
- 112: zweiter Halterahmen
- 113: Einrichtung zum Erfassen einer Verkehrssituation
- 114: Fotografische Erfassungseinrichtung
- 116: Gehäuse
- 117: Beleuchtungseinrichtung
- 118: Tür
- 120: erstes Gehäuse
- 122: zweites Gehäuse
- 124: Flügeltür
- 126: Fenster
- 228: Türgriff
- 330: autonome Energieversorgungseinheit
- 332: innenliegende Fixierelemente
- 434: Bodenplatte
- 436: Loch
- 438: Aussparung

## Patentansprüche

1. Vorrichtung (100) für eine Anlage (102) zur Verkehrsüberwachung von Fahrzeugen (104) im Straßenverkehr, wobei die Vorrichtung (100) einen ersten Halterahmen (110) und einen zweiten Halterahmen (112) aufweist, die in zumindest einem Gehäuse (116) angeordnet sind, welches mit zumindest einer Tür ausgestattet ist, wobei der erste Halterahmen (110) und der zweite Halterahmen (112) mit innenliegenden Fixierelementen (332) gegeneinander sicherbar oder gesichert sind, wobei zumindest der erste Halterahmen (110, 112) eine quaderförmige, Form aufweist, wobei in dem ersten Halterahmen (110) zumindest eine Einrichtung (113) zum Erfassen einer Verkehrssituation anordenbar oder angeordnet ist und **dadurch gekennzeichnet, dass** bei geöffneter Tür zumindest der erste Halterahmen (110) von vier Seiten zugänglich ist.

2. Vorrichtung (100) gemäß Anspruch 1, bei der der zweite Halterahmen (112) an der dem ersten Halterahmen (110) gegenüberliegenden Seite mit einer an einem Messplatz (106) montierten Bodenplatte (434) fixierbar ist, wobei die Bodenplatte (434) in Bezug auf den Messplatz (106) in einem Toleranzbereich ausrichtbar ist.

3. Vorrichtung (100) gemäß Anspruch 2, bei der der zweite Halterahmen (112) in einem Toleranzbereich um ein ganzzahliges Vielfaches von 90° verdreht auf der Bodenplatte (434) montierbar ist, insbesondere in einem Toleranzbereich um 90° oder 180° oder 270° verdreht montierbar ist.

4. Vorrichtung (100) gemäß einem der vorangegangenen Ansprüche, **gekennzeichnet durch** zumindest ein Gehäuse (116), welches mit zumindest einer Tür (118) ausgestattet ist, insbesondere wobei der erste (110) und/oder zweite (112) Halterahmen in den Gehäuse anordenbar oder angeordnet sind.

5. Vorrichtung (100) gemäß Anspruch 4, bei dem das Gehäuse (116) zumindest eine Flügeltüre (124), insbesondere zwei Flügeltüren (124), aufweist.

6. Vorrichtung (100) gemäß einem der Ansprüche 4 bis 5, bei dem der erste Halterahmen (110) ein erstes Gehäuse (120) aufweist und der zweite Halterahmen (112) ein vom ersten Gehäuse (120) unterschiedliches zweites Gehäuse (122) aufweist.

7. Vorrichtung (100) gemäß einem der Ansprüche 4 bis 6, bei dem das Gehäuse (116, 120, 122) auf drei Seiten des Gehäuses (116, 120, 122) zumindest je ein Fenster(126) aufweist, insbesondere wobei die Einrichtung (113) zum Erfassen zumindest ein Teilelement (113) aufweist, welches zum Aussenden oder Empfangen von elektromagnetischer Strahlung durch das zumindest ein Fenster (126) ausgerichtet ist.

8. Vorrichtung (100) gemäß einem der Ansprüche 4 bis 7, bei dem das Gehäuse (116, 120, 122) eine spezifische Schutzklasse aufweist, insbesondere die durch eine vorbestimmte Auswahl eines Materials des Gehäuses (116, 120, 122) festgelegt ist.

9. Vorrichtung (100) gemäß einem der Ansprüche 4 bis 8, bei dem das Gehäuse (116, 120, 122) schusssicher ausgebildet ist.

10. Vorrichtung (100) gemäß einem der vorangegangenen Ansprüche, bei dem der zweite Halterahmen (112) als eine autonome Energieversorgungseinheit (330) ausgebildet ist oder alternativ in dem zweiten Halterahmen (112) eine autonome Energieversorgungseinheit (330) angeordnet ist.

## Claims

1. Device (100) for a system (102) for traffic monitoring of vehicles (104) in road traffic, wherein the device (100) comprises a first mounting frame (110) and a second mounting frame (112), which are arranged in at least one housing (116) which is provided with at least one door, wherein the first mounting frame (110) and the second mounting frame (112) can be secured or are secured relative to each other by inner fixing elements (332), wherein at least the first mounting frame (110, 112) has a cuboidal shape, wherein at least one device (113) for recording a traffic situation can be disposed or is disposed in the first mounting frame (110), and **characterized in that,** when the door is open, at least the first mounting frame (110) is accessible from four sides.

2. Device (100) according to Claim 1, **wherein** the second mounting frame (112) can be fixed on the side opposite the first mounting frame (110) to a base plate (434) mounted on a measurement station (106), wherein the base plate (434) can be oriented in relation to the measurement station (106) within a tolerance range.

3. Device (100) according to Claim 2, **wherein** the second mounting frame (112) can be mounted on the base plate (434) rotated by a whole number multiple of 90° within a tolerance range, especially can be mounted rotated by 90° or 180° or 270° within a tolerance range.

4. Device (100) according to any one of the preceding claims, **characterized by** at least one housing (116), which is fitted with at least one door (118), especially wherein the first (110) and/or second (112) mounting frame can be disposed or is/are disposed in the housing.

5. Device (100) according to Claim 4, **wherein** the housing (116) comprises at least one hinged door (124), especially two hinged doors (124).

6. Device (100) according to one of Claims 4 to 5, **wherein** the first mounting frame (110) comprises a first housing (120) and the second mounting frame (112) comprises a second housing (122) different from the first housing (120).

7. Device (100) according to any one of Claims 4 to 6, **wherein** the housing (116, 120, 122) comprises at least one window (126) on each of three sides of the housing (116, 120, 122), especially wherein the device (113) for recording comprises at least one sub-element (113), which is designed for sending or receiving electromagnetic radiation through the at least one window (126).

8. Device (100) according to any one of Claims 4 to 7, **wherein** the housing (116, 120, 122) has a specific protection class, especially specified by a predetermined choice of a material of the housing (116, 120, 122).

9. Device (100) according to any one of Claims 4 to 8, **wherein** the housing (116, 120, 122) is designed to be bulletproof.

10. Device (100) according to any one of the preceding claims, **wherein** the second mounting frame (112) is designed as an autonomous energy supply unit (330) or alternatively an autonomous energy supply unit (330) is disposed in the second mounting frame (112).

## Revendications

1. Arrangement (100) pour une installation (102) servant à la surveillance du trafic de véhicule (104) en circulation routière, le dispositif (100) possédant un premier cadre de maintien (110) et un deuxième cadre de maintien (112) qui sont disposés dans au moins un boîtier (116), lequel est équipé d'au moins une porte, le premier cadre de maintien (110) et le deuxième cadre de maintien (112) pouvant être ou étant bloqués l'un contre l'autre par des éléments d'immobilisation (332) internes, au moins le premier cadre de maintien (110, 112) présentant une forme parallélépipédique, au moins un dispositif (113) destiné à détecter une situation de trafic pouvant être ou étant disposé dans le premier cadre de maintien (110), **caractérisé en ce que** lorsque la porte est ouverte, au moins le premier cadre de maintien (110) est accessible depuis quatre côtés.

2. Arrangement (100) selon la revendication 1, avec lequel le deuxième cadre de maintien (112) peut être immobilisé au niveau du deuxième côté à l'opposé du premier cadre de maintien (110) par une plaque de fond (434) montée au niveau d'un emplacement de mesure (106), la plaque de fond (434) pouvant être orientée dans une plage de tolérance par rapport à l'emplacement de mesure (106) .

3. Arrangement (100) selon la revendication 2, avec lequel le deuxième cadre de maintien (112) peut être monté sur la plaque de fond (434) tourné dans une plage de tolérance autour d'un multiple entier de 90°, peut notamment être monté tourné dans une plage de tolérance autour de 90° ou de 180° ou de 270°.

4. Arrangement (100) selon l'une des revendications précédentes, **caractérisé par** au moins un boîtier (116) qui est équipé d'au moins une porte (118), le premier (110) et/ou le deuxième cadre de maintien (112) pouvant être ou étant notamment disposés dans le boîtier.

5. Arrangement (100) selon la revendication 4, avec lequel le boîtier (116) possède une porte à double battant (124), notamment deux portes à double battant (124) .

6. Arrangement (100) selon l'une des revendications 4 à 5, avec lequel le premier cadre de maintien (110) possède un premier boîtier (120) et le deuxième cadre de maintien (112) possède un deuxième boîtier (122) différent du premier boîtier (120).

7. Arrangement (100) selon l'une des revendications 4 à 6, avec lequel le boîtier (116, 120, 122) possède sur trois côtés du boîtier (116, 120, 122) respectivement au moins une fenêtre (126), le dispositif (113) de détection comprenant notamment au moins un élément partiel (113) qui est orienté de façon à émettre ou recevoir un rayonnement électromagnétique à travers l'au moins une fenêtre (126) .

8. Arrangement (100) selon l'une des revendications 4 à 7, avec lequel le boîtier (116, 120, 122) possède une classe de protection spécifique, qui est notamment fixée par une sélection prédéterminée d'un matériau du boîtier (116, 120, 122).

9. Arrangement (100) selon l'une des revendications 4 à 8, avec lequel le boîtier (116, 120, 122) est configuré à l'épreuve des balles.

10. Arrangement (100) selon l'une des revendications précédentes, avec lequel le deuxième cadre de maintien (112) est réalisé sous la forme d'une unité d'alimentation en énergie (330) autonome ou, en variante, une unité d'alimentation en énergie (330) autonome est disposée dans le deuxième cadre de maintien (112).
